Europäisches Patentamt

(19) European Patent Office

Office européen des brevets

(11) EP 0 709 687 A2

(12) EUROPEAN PATENT APPLICATION

(43) Date of publication:
01.05.1996 Bulletin 1996/18

(51) Int. Cl.⁶: G01R 31/317

(21) Application number: 95306748.5

(22) Date of filing: 25.09.1995

(84) Designated Contracting States:
DE FR IT

(30) Priority: 28.10.1994 GB 9421842

(71) Applicant: Marconi Instruments Limited
Stevenage, Hertfordshire SG1 2BA (GB)

(72) Inventor: Woodall, Kenneth Anthony
Tring, Hertfordshire HP23 5HF (GB)

(74) Representative: McGowan, Nigel George
The General Electric Company plc
GEC Patent Department
Waterhouse Lane
Chelmsford, Essex CM1 2QX (GB)

(54) **An apparatus for testing the quality of the logic levels of a digital signal**

(57) An apparatus for testing the quality of the logic levels of a digital signal comprising: analogue comparator means (9) and switch means (11), said comparator means (9) receiving at one input thereto said digital signal and at the other input thereto a signal of one of a plurality of predetermined levels switched to said comparator means (9) by said switch means (11), said switch means (11) switching between the plurality of predetermined levels in dependence on the logic levels expected to be received at said one input of said comparator means (9), the output of said comparator means (9) providing an indication of the quality of the logic levels of said digital signal.

Fig.2.

APPARATUS OUTPUT

SIGNAL UNDER TEST

9
11
13 HIGH THRESHOLD
15 LOW THRESHOLD
17 HIGH / LOW SELECT

EP 0 709 687 A2

## Description

This invention relates to an apparatus for testing the quality of the logic levels of a digital signal.

The invention finds particular application in testing the logic levels of signals derived from circuit boards under test. It is known to test circuit boards by applying potentials to circuit nodes of the board and monitoring for the expected responses of the circuit to these potentials. The potentials are generated by an automatic test equipment (ATE) central control system and applied to the circuit nodes by an in-circuit test (ICT) fixture of the equipment which supports the circuit board. The fixture comprises a so called bed of nails which contact the circuit nodes. The responses of the circuit picked-up by the bed of nails are passed to the central control system. The control system has full knowledge of the circuit under test and therefore knows what responses to expect to the various patterns of potentials it generates.

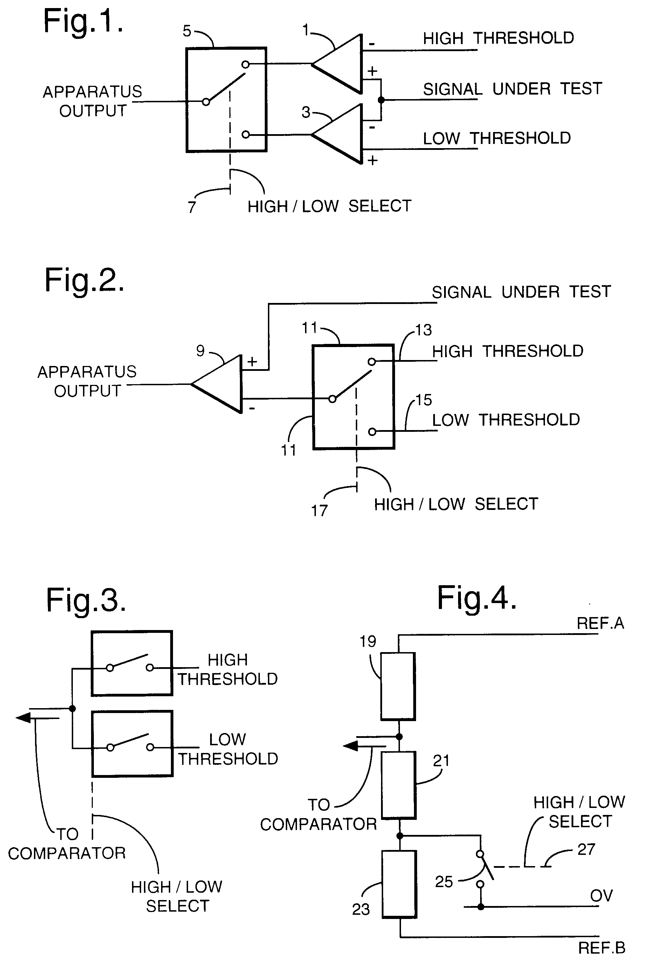

A known apparatus for testing the quality of the logic levels of a digital signal is shown schematically in Figure 1 of the accompanying drawings. The apparatus comprises two analogue comparators 1, 3 and a switch 5. A signal of a first predetermined level is supplied to the negative input of comparator 1. It is this signal which defines the "high threshold" for the test, i.e. for a logic level of the signal under test to be a good high its voltage must be above that of the first predetermined level. For example, if TTL logic is being used, the high threshold is 2.4V. A signal of a second predetermined level is supplied to the positive input of comparator 3. It is this signal which defines the "low threshold" for the test, i.e. for a logic level of the signal under test to be a good low its voltage must be below that of the second predetermined level. For example, if TTL logic is being used, the low threshold is 0.4V. The digital signal under test is supplied to both the positive input of comparator 1 and the negative input of comparator 3. Switch 5 switches between the outputs of comparators 1 and 3 to provide the apparatus output.

In operation, if a high logic level of the signal under test is expected, switch 5 is caused by means of connection 7 to select the output of comparator 1. If the high is good, it will be above the high threshold and comparator 1, and hence the apparatus, will output a one indicating a good high. However, if the high is bad, it will be below the high threshold and comparator 1, and hence the apparatus, will output a zero indicating a bad high. If a low logic level of the signal under test is expected, switch 5 is caused by means of connection 7 to select the output of comparator 3. If the low is good, it will be below the low threshold and comparator 3, and hence the apparatus, will output a one indicating a good low. If the low is bad, it will be above the low threshold and comparator 3, and hence the apparatus, will output a zero indicating a bad low.

According to the present invention there is provided an apparatus for testing the quality of the logic levels of a digital signal comprising: analogue comparator means and switch means, said comparator means receiving at one input thereto said digital signal and at the other input thereto a signal of one of a plurality of predetermined levels switched to said comparator means by said switch means, said switch means switching between the plurality of predetermined levels in dependence on the logic levels expected to be received at said one input of said comparator means, the output of said comparator means providing an indication of the quality of the logic levels of said digital signal.

An apparatus according to the present invention, therefore, includes only one analogue comparator means, as compared to the two required in the known apparatus of Figure 1. There is therefore a cost saving. Since the aforementioned automatic test equipment requires many, e.g. 500, apparatus for testing logic levels, this cost saving becomes significant.

An apparatus in accordance with the present invention will now be described, by way of example, with reference to the accompanying drawings, in which:

Figure 1, already referred to, is a schematic diagram of a known apparatus;
Figure 2 is a schematic diagram of the apparatus in accordance with the present invention; and
Figures 3 and 4 illustrate modifications to the apparatus of Figure 2.

Referring to Figure 2, the apparatus according to the invention comprises an analogue comparator 9 and a switch 11. A signal defining the high threshold is supplied to input 13 of switch 11. A signal defining the low threshold is supplied to the other input 15 of switch 11. Switch 11 switches between inputs 13 and 15 to provide a supply to the negative input of comparator 9. The digital signal under test is supplied to the positive input of comparator 9. The output of the apparatus is the output of comparator 9.

In operation, if a high logic level of the signal under test is expected, switch 11 is caused by means of connection 17 to connect the high threshold signal to the negative input of comparator 9. If the high is good, it will be above the high threshold and comparator 9, and hence the apparatus, will output a one indicating a good high. If the high is bad, it will be below the high threshold and comparator 9, and hence the apparatus, will output a zero indicating a bad high. If a low logic level of the signal under test is expected, switch 11 is caused by means of connection 17 to connect the low threshold signal to the negative input of comparator 9. If the low is good, it will be below the low threshold and comparator 9, and hence the apparatus, will output a zero indicating a good low. If the low is bad, it will be above the low threshold and comparator 9, and hence the apparatus, will output a one indicating a bad low.

Since an apparatus output of one, and also an apparatus output of zero, can mean a good or a bad logic level depending on whether a high or a low is being tested, knowledge of the particular logic level being tested is required when interpreting an apparatus output. This is to be contrasted with the prior art apparatus of Figure 1 where an output of one always means a good logic level, be it a low or a high, and an output of zero always means a bad logic level. In other words an output of one can be considered a 'pass' result, and an output of zero a 'fail' result. Thus, in the prior art apparatus, knowledge of the particular logic level being tested is not required when interpreting an apparatus output.

An addition may be made to the Figure 2 apparatus according to the invention so that it provides a pass/fail output. If one input of an exclusive NOR gate is connected to the apparatus output (the output of comparator 9), and the other input is connected to connection 17, the exclusive NOR gate will output a one when there is a good high or a good low and a zero when there is a bad high or a bad low. To explain, if a high is tested to be good there will be a one output by comparator 9 and a one on connection 17. The supply of two ones to an exclusive NOR results in a one, a pass result. If a low is tested to be good there will be a zero output by comparator 9 and a zero on connection 17. The supply of two zeroes to an exclusive NOR results in a one, a pass result. If a high is tested to be bad there will be a zero output by comparator 9 and a one on connection 17. The supply of a zero and a one to an exclusive NOR results in a zero, a fail result. If a low is tested to be bad there will be a one output by comparator 9 and a zero on connection 17. The supply of a one and a zero to an exclusive NOR results in a zero, a fail result. The cost of adding the exclusive NOR gate is minimal, especially when the gate is configured using array logic.

Considering the aforementioned particular application of the present invention in the testing of circuit boards using ATE, ATE operate typically in the range 1-100 MHz, i.e. the time between one test (the application of a particular pattern of potentials to the circuit and the monitoring of the responses) and the next is in the range 10-1000ns. Thus, switch 11 of Figure 2 must be capable of switching at these rates. A semiconductor analogue switch may be used. This may comprise a single 'change-over' switch, as shown in Figure 2, or two 'make-only' switches, i.e. two switches, each of which is connected to a respective threshold, and only one of which is made/closed at any given time to supply the required threshold. Figure 3 shows the two make-only switches.

An alternative to the switches of Figures 2 and 3 is the switch shown in Figure 4. This comprises three resistors 19, 21, 23, suitably of equal value, and one switch 25 to a fixed voltage level, say zero volts. Switch 25 switches the junction between resistors 21 and 23 to zero volts. The threshold input to comparator 9 of Figure 2 is derived from the junction between resistors 19 and 21. The side of resistor 19 remote from resistor 21 is maintained at reference voltage A. The side of resistor 23 remote from resistor 21 is maintained at reference voltage B. With switch 25 closed the threshold supplied will equal A/2. With switch 25 open the threshold supplied will equal $B + 2 (A - B)/3$. Thus, with the correct choice of voltages A and B the desired high and low thresholds can be achieved. For example, if low and high thresholds of 0.4V and 2.4V respectively are required, then A is set to 0.8V, and B to 5.6V. Switch 25 is opened to test a high and closed to test a low by means of connection 27.

Switch 25 may be analogue. Alternatively, it may take the form of an open collector transistor switch. The collector of the transistor would be connected to the junction between resistors 21 and 23, the emitter to zero volts, and the base to connection 27. One advantage of using a digital as opposed to an analogue switch is reduced cost, especially when the switch is configured using array logic, for example the same used to configure the aforementioned exclusive NOR gate. Another advantage is higher speed of operation.

It is to be appreciated that the intermediate state of a tri-state signal under test may be tested by, whilst the intermediate level is present, testing for a high, then testing for a low (or vice versa). If both tests are failed then the intermediate state is good, otherwise it is bad.

It is also to be appreciated that the apparatus need not switch only two thresholds to the comparator. For example, if it is desired that the apparatus be capable of testing both TTL and CMOS highs and lows, then four levels would be required to be switched to the comparator.

## Claims

1. An apparatus for testing the quality of the logic levels of a digital signal comprising: analogue comparator means (9) and switch means (11), said comparator means (9) receiving at one input thereto said digital signal and at the other input thereto a signal of one of a plurality of predetermined levels switched to said comparator means (9) by said switch means (11), said switch means (11) switching between the plurality of predetermined levels in dependence on the logic levels expected to be received at said one input of said comparator means (9), the output of said comparator means (9) providing an indication of the quality of the logic levels of said digital signal.

2. An apparatus according to Claim 1 wherein said switch means (11) comprises an analogue switch.

3. An apparatus according to Claim 1 wherein: said plurality of predetermined levels is two predetermined levels; and said switch means (11) comprises a network of three series connected resistors (19, 21, 23) and a switch (25) to a fixed voltage level, each side of the resistor network (19, 21, 23) being maintained at a reference potential, said switch (25) to a fixed voltage level being connected to the junction between the middle resistor (21) and the resistor (23) to one side of the resistor network (19, 21, 23), the junction between the middle resistor (21) and the resistor (19) to the other side of the network (19, 21, 23) being connected to said other input of said comparator means (9).

4. An apparatus according to Claim 3 wherein said switch (25) to a fixed voltage level is an analogue switch.

5. An apparatus according to Claim 3 wherein said switch (25) to a fixed voltage level is a digital switch.

6. An apparatus according to Claim 1 wherein: said plurality of predetermined levels is two predetermined levels; and an exclusive NOR gate is connected, one input to the output of said comparator means (9), the other input to a control connection to said switch means (11), so that the output of said exclusive NOR gate is always one logic level when there is a good logic level and always the other logic level when there is a bad logic level.

7. An equipment for testing circuits by applying potentials to the circuit and monitoring the circuit for the expected responses to these potentials including apparatus according to any one of the preceding claims for testing the quality of the logic levels of said responses.

# Fig.1.

APPARATUS OUTPUT

5

7 HIGH / LOW SELECT

1

HIGH THRESHOLD

SIGNAL UNDER TEST

3

LOW THRESHOLD

# Fig.2.

SIGNAL UNDER TEST

APPARATUS OUTPUT

9

11

11

13 HIGH THRESHOLD

15 LOW THRESHOLD

17 HIGH / LOW SELECT

# Fig.3.

HIGH THRESHOLD

LOW THRESHOLD

TO COMPARATOR

HIGH / LOW SELECT

# Fig.4.

REF.A

19

21

TO COMPARATOR

23

25

27 HIGH / LOW SELECT

0V

REF.B